# EUROPEAN PATENT APPLICATION

(11) **EP 4 716 393 A1**
(43) Date of publication of application: **25.03.2026**
(21) Application number: 25203368.3
(22) Date of filing: 19.09.2025
(51) Int. Cl.: H05K 7/20

(54) **COOLANT DISTRIBUTION UNIT SOFT START PUMP CONTROLS**

(30) Priority: 19.09.2024 US 202463696534 P; 18.09.2025 US 202519332217
(71) Applicant: Vertiv Corporation, Westerville, OH 43082 (US)
(72) Inventor: SALEH, Adam Mustafa, Westerville, 43082 (US); KING, Jeremy Ryan, Westerville, 43082 (US)
(74) Representative: Bryn-Jacobsen, Caelia

(57) **Abstract**

A coolant distribution unit of a liquid cooling system comprises: a plurality of pumps configured to circulate coolant within the liquid cooling system, where a subset of the plurality of pumps is capable of handling a full operation load of the liquid cooling system when at least one pump of the plurality of pumps is not in operation; and a controller communicatively coupled to the plurality of pumps. The controller is configured to: in response to determining that the pump has been enabled, adjust the pump and remaining pumps of the plurality of pumps to a first pump speed; and adjust the pump and the remaining pumps to a second pump speed, where the first pump speed corresponds to an intermediate operational speed lower than the second pump speed and the second pump speed corresponds to a final operational speed.

## Description

### CROSS REFERENCE TO RELATED APPLICATIONS

This U.S. Non-Provisional Patent Applications claims the benefit of and priority to U.S. Provisional Patent Application Serial No. 63/696,534 filed September 19, 2024.

### TECHNICAL FIELD

The present disclosure relates to a coolant distribution unit (CDU) of a liquid cooling systems for electronic equipment, particularly in data centers and other high-performance computing environments.

### BACKGROUND

A coolant distribution unit (CDU) is a component of a liquid cooling system. CDUs are configured to manage high heat loads for accelerated compute and high-density data center environments, providing critical cooling capacity and heat removal functions.

CDUs may also be designed to include redundant pumps. For illustration purposes, assume a CDU has three pumps and two pumps may be capable of handling the load, with a third pump serving as a redundant backup. In typical operations, all three pumps may run at lower speeds to optimize energy efficiency. However, in the event of a pump failure, the remaining two pumps will ramp up to maintain the required flow rate while the third pump is being serviced. After the third pump is serviced and brought back online, the third pump ramps up to the same speed as the other two pumps. This may cause a pressure spike in the cooling fluid loop.

A solution is needed for preventing such pressure spikes in a liquid cooling system.

### SUMMARY

This disclosure relates generally to a coolant distribution unit (CDU) of a liquid cooling system.

An aspect of the disclosed examples includes a coolant distribution unit of a liquid cooling system. The coolant distribution unit comprises: a plurality of pumps configured to circulate coolant within the liquid cooling system, where a subset of the plurality of pumps is capable of handling a full operation load of the liquid cooling system when at least one pump of the plurality of pumps is not in operation; and a controller communicatively coupled to the plurality of pumps. The controller is configured to: determine whether a pump of the plurality of pumps has been enabled after previously being disabled; in response to determining that the pump has been enabled, adjust the pump and remaining pumps of the plurality of pumps to a first pump speed; and subsequent to the pump and the remaining pumps being adjusted to the first pump speed, adjust the pump and the remaining pumps to a second pump speed, where the first pump speed corresponds to an intermediate operational speed and the second pump speed corresponds to a final operational speed.

Another aspect of the disclosed examples includes a coolant distribution unit of a liquid cooling system that includes: a plurality of pumps configured to circulate coolant within the liquid cooling system; and a controller communicatively coupled to the plurality of pumps, the controller configured to: determine whether a pump of the plurality of pumps has been enabled after previously being disabled; in response to determining that the pump has been enabled: adjust a pump speed of the pump to a first pump speed; and adjust a pump speed of at least one other pump of the plurality of pumps to the first pump speed; and after a first period, adjust the pump speed of the pump and the pump speed of the at least one other pump to a second pump speed.

Another aspect of the disclosed examples includes a method that includes: determining whether a pump of a plurality of pumps has been enabled after previously being disabled, the plurality of pumps being associated with a coolant distributing unit; in response to a determination that that the pump has been enabled after previously being disabled: adjusting a pump speed of the pump to a first pump speed; and adjusting a pump speed of at least one other pump of the plurality of pumps to the first pump speed; and after a first period, adjusting the pump speed of the pump and the pump speed of the at least one other pump to a second pump speed.

These and other aspects of the present disclosure are disclosed in the following detailed description of the examples, the appended claims, and the accompanying figures.

### BRIEF DESCRIPTION OF THE DRAWINGS

The disclosure is best understood from the following detailed description when read in conjunction with the accompanying drawings. It is emphasized that, according to common practice, the various features of the drawings are not to scale. On the contrary, the dimensions of the various features are arbitrarily expanded or reduced for clarity.
FIG. 1 illustrates an exemplary example of a coolant distribution unit (CDU) of a liquid cooling system configured to manage and balance the operation of multiple pumps in a liquid cooling system, according to the principles of the present disclosure.
FIG. 2 depicts a flowchart of a method for managing and balancing multiple pumps of a liquid cooling system in response re-enabling a previously disable pump while preventing pressure spikes, according to the principles of the present disclosure.
FIG. 3 illustrates the behavior of a plurality of pumps in a liquid cooling system over time, according to the principles of the present disclosure.
FIG. 4 depicts the outlet of pressure of the liquid cooling system over time, according to the principles of the present disclosure.
FIG. 5 is a block diagram of an example computing device that may be used to implement examples, according to the principles of the present disclosure.

Those skilled in the art will appreciate and understand that, according to common practice, various features of the drawings discussed below are not necessarily drawn to scale, and that dimensions of various features and elements of the drawings may be expanded or reduced to more clearly illustrate the examples of the present disclosure described herein.

### DETAILED DESCRIPTION

The following discussion is directed to various examples of the disclosure. Although one or more of these examples may be preferred, the examples disclosed should not be interpreted, or otherwise used, as limiting the scope of the disclosure, including the claims. In addition, one skilled in the art will understand that the following description has broad application, and the discussion of any example is meant only to be exemplary of that example, and not intended to intimate that the scope of the disclosure, including the claims, is limited to that example.

The present specification and accompanying drawings disclose one or more examples that incorporate the features of the present disclosure. The scope of the present disclosure is not limited to the disclosed examples. The disclosed examples merely exemplify the present disclosure, and modified versions of the disclosed examples are also encompassed by the present disclosure. Examples of the present disclosure are defined by the claims appended hereto.

References in the specification to "one example," "an example," "an example," etc., indicate that the example described may include a particular feature, structure, or characteristic, but every example may not necessarily include the particular feature, structure, or characteristic. Moreover, such phrases are not necessarily referring to the same example. Further, when a particular feature, structure, or characteristic is described in connection with an example, it is submitted that it is within the knowledge of one skilled in the art to effect such feature, structure, or characteristic in connection with other examples whether or not explicitly described.

In the discussion, unless otherwise stated, adjectives such as "substantially," "approximately," and "about" modifying a condition or relationship characteristic of a feature or features of an example of the disclosure, are understood to mean that the condition or characteristic is defined to be within tolerances that are acceptable for operation of the example for an application for which it is intended.

Furthermore, it should be understood that spatial descriptions (e.g., "above," "below," "up," "left," "right," "down," "top," "bottom," "vertical," "horizontal," etc.) used herein are for purposes of illustration only, and that practical implementations of the structures described herein can be spatially arranged in any orientation or manner.

The word "example" is used herein to mean serving as an example, instance, or illustration. Any aspect or design described herein as "example" is not necessarily to be construed as preferred or advantageous over other aspects or designs. Rather, use of the word "example" is intended to present concepts in a concrete fashion. As used in this application, the term "or" is intended to mean an inclusive "or" rather than an exclusive "or." That is, unless specified otherwise, or clear from context, "X includes A or B" is intended to mean any of the natural inclusive permutations. That is, if X includes A; X includes B; or X includes both A and B, then "X includes A or B" is satisfied under any of the foregoing instances. In addition, the articles "a" and "an" as used in this application and the appended claims should generally be construed to mean "one or more" unless specified otherwise or clear from context to be directed to a singular form. Moreover, use of the term "an implementation" or "one implementation" throughout is not intended to mean the same example or implementation unless described as such.

Numerous exemplary examples are described as follows. It is noted that any section/subsection headings provided herein are not intended to be limiting. Examples are described throughout this document, and any type of example may be included under any section/subsection. Furthermore, examples disclosed in any section/subsection may be combined with any other examples described in the same section/subsection and/or a different section/subsection in any manner.

A coolant distribution unit (CDU) is a component of a liquid cooling system. CDUs are configured to manage high heat loads for accelerated compute and high-density data center environments, providing critical cooling capacity and heat removal functions.

CDUs may also be designed to include redundant pumps. For illustration purposes, assume a CDU has three pumps and two pumps may be capable of handling the load, with a third pump serving as a redundant backup. In typical operations, all three pumps may run at lower speeds to optimize energy efficiency. However, in the event of a pump failure, the remaining two pumps will ramp up to maintain the required flow rate while the third pump is being serviced. After the third pump is serviced and brought back online, the third pump ramps up to the same speed as the other two pumps. This may cause a pressure spike in the cooling fluid loop.

This pressure spike can cause several issues in liquid cooling applications. For example, if the liquid cooled servers lack proper protection, this pressure spike could damage the cold plates. As another example, if a pressure relief valve is present on the technical water loop, the pressure relief valve could be triggered by the pressure strike, introducing fluid into the white space and activating a leak detection system. Additionally, other components in the hydronic loop may not be rated correctly to handle the increased pressure, which could result in a leak. Examples disclosed herein are directed to a coolant distribution unit configured to address the issues discussed above.

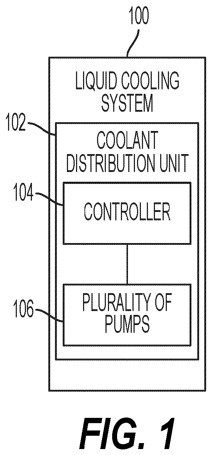

To help further illustrate the foregoing, FIG. 1 illustrates an exemplary example of a CDU of a liquid cooling system configured to manage and balance the operation of multiple pumps in a liquid cooling system to ensure efficient and stable cooling performance while preventing pressure spikes. As depicted in FIG. 1, a CDU 102 of a liquid cooling system 100 includes a plurality of pumps 106 and a controller 104. Although the controller 104 is depicted as part of the CDU 102 in FIG. 1, in some examples, the controller 104 may be separate from CDU 102.

In FIG. 1, the plurality of pumps 106 are configured to circulate coolant throughout the liquid cooling system 100. More specifically, the plurality of pumps 106 work together to manage the coolant requirements of the liquid cooling system 100. In some examples, one or more pumps of the plurality of pumps 106 may be designated as redundant, while remaining pumps of the plurality of pumps 106 are sufficient to handle the full load of the liquid cooling system 100 when the one or more redundant pumps are offline or not in operation. For example, under normal operating conditions, all pumps of the plurality of pumps 106 may be used simultaneously but at lower speeds to optimize energy efficiency. In the event that a pump of the plurality of pumps 106 fails or needs to be taken offline for maintenance, the speed of the remaining pumps of the plurality of pumps 106 may be ramped up to compensate and meet the coolant requirements of the liquid cooling system 100.

As depicted in FIG. 1, the plurality of pumps 106 are communicatively coupled to the controller 104. The controller 104 may be configured to continuously monitor the operational status of all pumps of the plurality of pumps 106. When a pump is disable, for example, due to maintenance or servicing, the controller 104 may log the pump's state. Once the servicing is complete, and the pump is re-enabled (e.g., by an operator via a Human Machine Interface (HMI)), the controller may detect this change through a signal sent by the pump or via the HMI when the operator reactivates the pump. The controller 104 may identify that the pump is now operational and initiate subsequent actions needed to integrate the pump back into the CDU 102.

Further, the controller 104 may be configured to manage the operation of the plurality of pumps 106. For example, upon detecting a change in the requirements of the liquid cooling system-such as the reactivation of a previously disable pump or change in cooling demand-the controller 104 may send commands to adjust the pump speeds of the plurality of pumps 106. In some examples, these adjustments may be gradual to prevent sudden shifts in pressure or coolant flow that could destabilize the liquid cooling system 100. Additionally, the controller 104 may use predefined pump speed settings to transition the pumps from an initial state to a desired operational state. The controller 104 may continuously monitor system parameters, such as pressure, flow rate, and temperature, to ensure that the pumps of the plurality of pumps 106 are operating at the appropriate speeds to balance the workload among the pumps and meet the cooling requirements of the liquid cooling system 100.

For example, upon detecting that a disabled pump has been reactivated, the controller 104 may initiate a gradual ramp up process of the re-enabled pump. The controller 104 may cause both the re-enabled pump and the currently active pumps to adjust their speeds to a predefined first pump speed. In some examples, the first pump speed may correspond to an intermediate operational speed that helps prevent sudden surges in pressure that could occur if the re-enabled pump was brought online at a full operational speed immediately. For example, the controller 104 may ramp up the re-enabled pump to a first pump speed and ramp down the currently active pumps to the first pump speed. Once the controller 104 confirms that all pumps of the plurality of pumps 106 have reached the first pump speed, the controller 104 may proceed to adjust the speeds of all pumps of the plurality of pumps 106-including both the re-enabled pump and the remaining active pumps-to a second pump speed. In some examples, the second pump speed may correspond to a final operational setpoint, where all pumps are balanced and operating at a required speed to meet the cooling demands of the liquid cooling system 100.

In some examples, the transition from the first pump speed to the second pump speed may be smooth and gradual. In some examples, the controller 104 is configured to adjust the re-enabled pump to the first ramp speed within a tunable first time period (e.g., fifteen seconds) and adjust the remaining active pumps to the first ramp speed within a tunable second time period (e.g., five seconds), where the first time period is longer than the second time period. In some examples, the re-enabled pump and the remaining active pumps may be adjusted concurrently.

In some examples, the first pump speed is set (e.g., by an operator) as an intermediate operational speed that is lower than the second pump speed. The intermediate operational speed allows the liquid cooling system to stabilize as pumps are brought back online. Once the pumps reach this intermediate operational speed, the controller 104 adjusts the pumps to the second pump speed, which corresponds to the final operational speed. This speed is calibrated to ensure that the workload is balanced across all pumps of the plurality of pumps. In some examples, the intermediate operational speed and final operational setpoint speed may be set by an operator during the commissioning of a liquid cooling system.

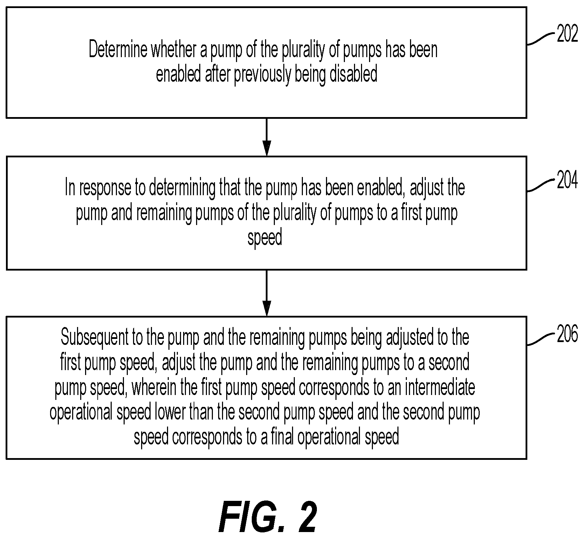

FIG. 2 depicts a flowchart 200 of a method for managing and balancing multiple pumps of a liquid cooling system in response re-enabling a previously disable pump, according to an example. As shown in FIG. 2, the method of flowchart 200 begins at step 202. In step 202, it is determined whether a pump of the plurality of pumps has been enabled after previously being disabled.

At step 204 in flowchart 200, in response to determining that the pump has been enabled, the pump and remaining pumps of the plurality of pumps is adjusted to a first pump speed.

At step 206 in flowchart 200, subsequent to the pump and the remaining pumps being adjusted to the first pump speed, the pump and the remaining pumps are adjusted to a second pump speed, where the first pump speed corresponds to an intermediate operational speed lower than the second pump speed and the second pump speed corresponds to a final operational speed.

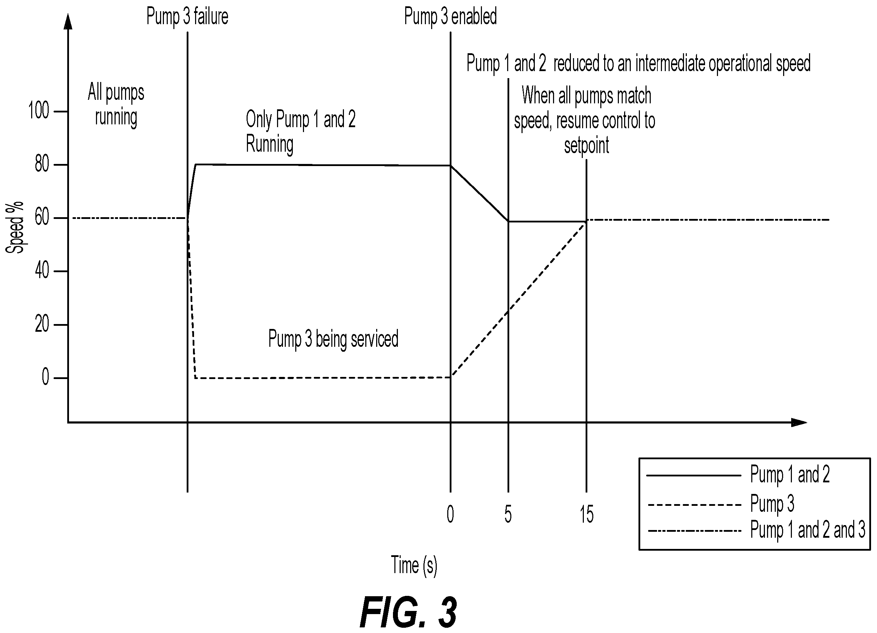

FIG. 3 illustrates the behavior of a plurality of pumps (e.g., Pump 1, Pump 2, and Pump 3) in a liquid cooling system over time. Initially, all three pumps are running at a set operational speed. At the point labeled "Pump 3 failure," Pump 3 stops working and only Pumps 1 and 2 continue to run. As Pump 3 is serviced (shown in the graph dropping to zero), Pumps 1 and 2 increase their output to handle the load, compensating for the loss of Pump 3. After servicing, Pump 3 is re-enabled, and the controller reduces the speeds of Pumps 1 and 2 to match an intermediate operational speed. Once all pumps reach the intermediate operational speed, the liquid cooling system resumes normal operation and the pumps are set to an operational speed.

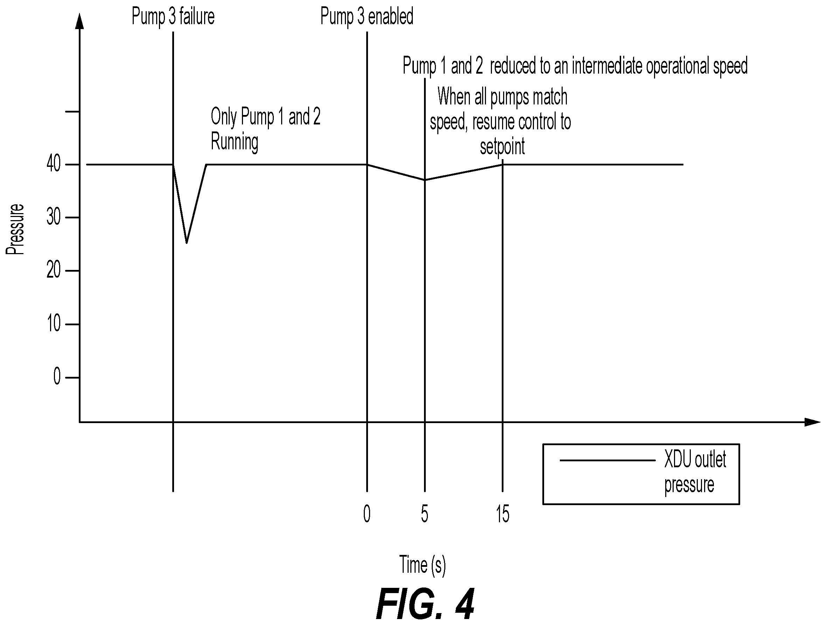

FIG. 4 depicts the outlet of pressure of the liquid cooling system at the XDU (cooling distribution unit) over time during the same sequence of events depicted in FIG. 3. When Pump 3 fails, the pressure momentarily drops as the liquid cooling system compensates for the loss of one pump. Pumps 1 and 2 continue running, maintaining pressure stability after an initial dip. Once Pump 3 is enabled again, the controller reduces the speeds of Pumps 1 and 2 to an intermediate operational speed, which leads to a slight adjustment in pressure. After all pumps are synchronized at the intermediate operational speed, the liquid cooling system increases speed to the final setpoint, allowing the outlet pressure to stabilize and return to the desired level.

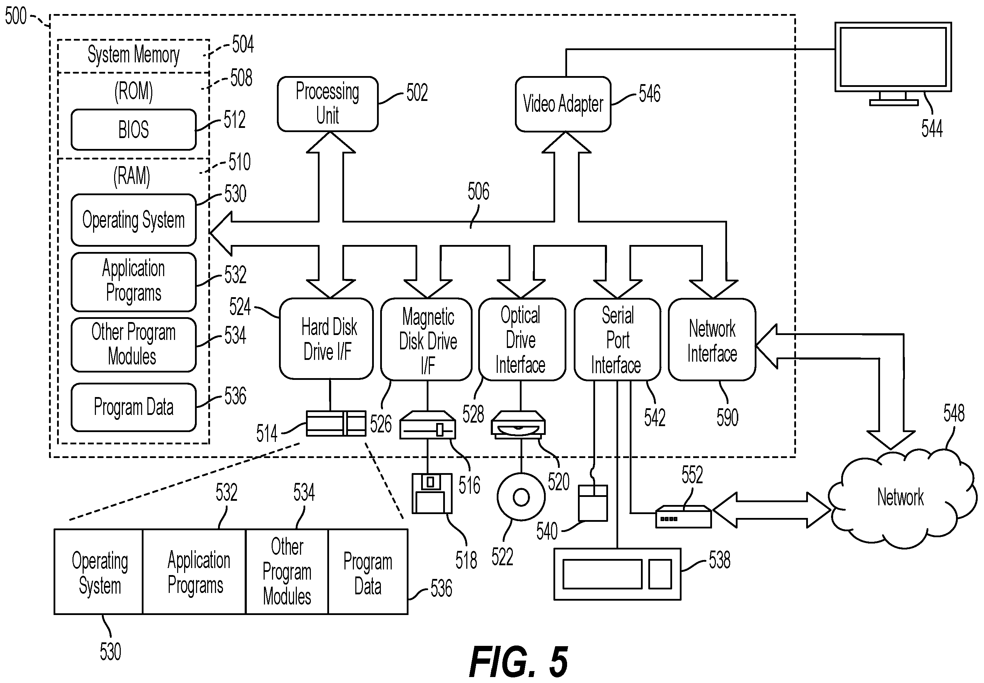

FIG. 5 depicts an example processor-based computer system 500 that may be used to implement various examples described herein, such as any of the examples described in the above and in reference to FIGS. 1-4. For example, processor-based computer system 500 may be used to implement any of the components of the liquid cooling system as described above in reference to FIGS. 1-4. The description of processor-based computer system 500 provided herein is provided for purposes of illustration and is not intended to be limiting. Examples may be implemented in further types of computer systems, as would be known to persons skilled in the relevant art(s).

As shown in FIG. 5, processor-based computer system 500 includes one or more processors, referred to as processor circuit 502, a system memory 504, and a bus 506 that couples various system components including system memory 504 to processor circuit 502. Processor circuit 502 is an electrical and/or optical circuit implemented in one or more physical hardware electrical circuit device elements and/or integrated circuit devices (semiconductor material chips or dies) as a central processing unit (CPU), a microcontroller, a microprocessor, and/or other physical hardware processor circuit. Processor circuit 502 may execute program code stored in a computer readable medium, such as program code of operating system 530, application programs 532, other programs 534, etc. Bus 506 represents one or more of any of several types of bus structures, including a memory bus or memory controller, a peripheral bus, an accelerated graphics port, and a processor or local bus using any of a variety of bus architectures. System memory 504 includes read only memory (ROM) 508 and random access memory (RAM) 510. A basic input/output system 512 (BIOS) is stored in ROM 508.

Processor-based computer system 800 also has one or more of the following drives: a hard disk drive 514 for reading from and writing to a hard disk, a magnetic disk drive 516 for reading from or writing to a removable magnetic disk 518, and an optical disk drive 520 for reading from or writing to a removable optical disk 522 such as a CD ROM, DVD ROM, or other optical media. Hard disk drive 514, magnetic disk drive 516, and optical disk drive 520 are connected to bus 506 by a hard disk drive interface 524, a magnetic disk drive interface 526, and an optical drive interface 528, respectively. The drives and their associated computer-readable media provide nonvolatile storage of computer-readable instructions, data structures, program modules and other data for the computer. Although a hard disk, a removable magnetic disk and a removable optical disk are described, other types of hardware-based computer-readable storage media can be used to store data, such as flash memory cards, digital video disks, RAMs, ROMs, and other hardware storage media.

A number of program modules may be stored on the hard disk, magnetic disk, optical disk, ROM, or RAM. These programs include operating system 530, one or more application programs 532, other programs 534, and program data 536. Application programs 532 or other programs 534 may include, for example, computer program logic (e.g., computer program code or instructions) for implementing the systems described above, including the examples described in reference to FIGS. 1-4.

A user may enter commands and information into processor-based computer system 500 through input devices such as keyboard 538 and pointing device 540. Other input devices (not shown) may include a microphone, joystick, game pad, satellite dish, scanner, a touch screen and/or touch pad, a voice recognition system to receive voice input, a gesture recognition system to receive gesture input, or the like. These and other input devices are often connected to processor circuit 502 through a serial port interface 542 that is coupled to bus 506, but may be connected by other interfaces, such as a parallel port, game port, or a universal serial bus (USB).

A display screen 544 is also connected to bus 506 via an interface, such as a video adapter 546. Display screen 544 may be external to, or incorporated in processor-based computer system 500. Display screen 544 may display information, as well as being a user interface for receiving user commands and/or other information (e.g., by touch, finger gestures, virtual keyboard, etc.). In addition to display screen 544, processor-based computer system 500 may include other peripheral output devices (not shown) such as speakers and printers.

Processor-based computer system 500 is connected to a network 548 (e.g., the Internet) through an adaptor or network interface 550, a modem 552, or other means for establishing communications over the network. Modem 552, which may be internal or external, may be connected to bus 506 via serial port interface 542, as shown in FIG.5, or may be connected to bus 506 using another interface type, including a parallel interface.

As used herein, the terms "computer program medium," "computer-readable medium," and "computer-readable storage medium" are used to generally refer to physical hardware media such as the hard disk associated with hard disk drive 514, removable magnetic disk 518, removable optical disk 522, other physical hardware media such as RAMs, ROMs, flash memory cards, digital video disks, zip disks, MEMs, nanotechnology-based storage devices, and further types of physical/tangible hardware storage media (including system memory 504 of FIG. 5). Such computer-readable storage media are distinguished from and non-overlapping with communication media (do not include communication media). Communication media typically embodies computer-readable instructions, data structures, program modules or other data in a modulated data signal such as a carrier wave. The term "modulated data signal" means a signal that has one or more of its characteristics set or changed in such a manner as to encode information in the signal. By way of example, and not limitation, communication media includes wireless media such as acoustic, RF, infrared and other wireless media, as well as wired media. Examples are also directed to such communication media.

As noted above, computer programs and modules (including application programs 532 and other programs 534) may be stored on the hard disk, magnetic disk, optical disk, ROM, RAM, or other hardware storage medium. Such computer programs may also be received via network interface 550, serial port interface 542, or any other interface type. Such computer programs, when executed or loaded by an application, enable processor-based computer system 500 to implement features of examples discussed herein. Accordingly, such computer programs represent controllers of processor-based computer system 500.

Implementations of the systems, algorithms, methods, instructions, etc., described herein can be realized in hardware, software, or any combination thereof. The hardware can include, for example, computers, intellectual property (IP) cores, application-specific integrated circuits (ASICs), programmable logic arrays, optical processors, programmable logic controllers, microcode, microcontrollers, servers, microprocessors, digital signal processors, or any other suitable circuit. In the claims, the term "processor" should be understood as encompassing any of the foregoing hardware, either singly or in combination. The terms "signal" and "data" are used interchangeably.

As used herein, the term module can include a packaged functional hardware unit designed for use with other components, a set of instructions executable by a controller (e.g., a processor executing software or firmware), processing circuitry configured to perform a particular function, and a self-contained hardware or software component that interfaces with a larger system. For example, a module can include an application specific integrated circuit (ASIC), a Field Programmable Gate Array (FPGA), a circuit, digital logic circuit, an analog circuit, a combination of discrete circuits, gates, and other types of hardware or combination thereof. In other examples, a module can include memory that stores instructions executable by a controller to implement a feature of the module.

Further, in one aspect, for example, systems described herein can be implemented using a general-purpose computer or general-purpose processor with a computer program that, when executed, carries out any of the respective methods, algorithms, and/or instructions described herein. In addition, or alternatively, for example, a special purpose computer/processor can be utilized which can contain other hardware for carrying out any of the methods, algorithms, or instructions described herein.

Further, all or a portion of implementations of the present disclosure can take the form of a computer program product accessible from, for example, a computer-usable or computer-readable medium. A computer-usable or computer-readable medium can be any device that can, for example, tangibly contain, store, communicate, or transport the program for use by or in connection with any processor. The medium can be, for example, an electronic, magnetic, optical, electromagnetic, or a semiconductor device. Other suitable mediums are also available.

Further examples are set out in the items below:
1. A coolant distribution unit of a liquid cooling system, the coolant distribution unit comprising:
   a plurality of pumps configured to circulate coolant within the liquid cooling system, wherein a subset of the plurality of pumps is configured to handle a full operation load of the liquid cooling system when at least one pump of the plurality of pumps is not in operation; and
   a controller communicatively coupled to the plurality of pumps, the controller configured to:
      determine whether a pump of the plurality of pumps has been enabled after previously being disabled,
      in response to determining that the pump has been enabled, adjust the pump and remaining pumps of the plurality of pumps to a first pump speed, and
   subsequent to the pump and the remaining pumps being adjusted to the first pump speed, adjust the pump and the remaining pumps to a second pump speed, wherein the first pump speed corresponds to an intermediate operational speed and the second pump speed corresponds to a final operational speed.
2. The coolant distribution unit of item 1, wherein the controller is further configured to ramp down the remaining pumps to the first pump speed in response to determining that the pump has been enabled.
3. The coolant distribution unit of item 1, wherein the controller is further configured to ramp up the pump to the first pump speed in response to determining that the pump has been enabled.
4. The coolant distribution unit of item 1, wherein the controller is further configured to adjust the remaining pumps to the first pump speed within a first time period.
5. The coolant distribution unit of item 4, wherein the controller is further configured to adjust the pump to the first pump speed within a second time period.
6. The coolant distribution unit of item 5, wherein the first time period is shorter than the second time period.
7. The coolant distribution unit of any one of the preceding items, wherein the second pump speed corresponds to a setpoint speed.

Further examples are et out the clauses below:
A coolant distribution unit of a liquid cooling system, the coolant distribution unit comprising:
   a plurality of pumps configured to circulate coolant within the liquid cooling system; and
   a controller communicatively coupled to the plurality of pumps, the controller configured to:
      determine whether a pump of the plurality of pumps has been enabled after previously being disabled;
      in response to determining that the pump has been enabled:
         adjust a pump speed of the pump to a first pump speed; and
         adjust a pump speed of at least one other pump of the plurality of pumps to the first pump speed; and
         after a first period, adjust the pump speed of the pump and the pump speed of the at least one other pump to a second pump speed.
2. The coolant distribution unit of clause 1, wherein the controller is further configured adjust the pump speed of the pump to the first pump speed by ramping up the pump speed of the pump to the first pump speed.
3. The coolant distribution unit of clause 1, wherein the controller is further configured adjust the pump speed of the at least one other the pump to the first pump speed by ramping down the pump speed of the at least one other pump to the first pump speed.
4. The coolant distribution unit of any one of the preceding clauses, wherein the controller is further configured to adjust the pump speed of the pump to the first pump speed over the first period.
5. The coolant distribution unit of clause 4, wherein the controller is further configured to adjust the pump speed of the at least one other pump to the first pump speed over a second period.
6. The coolant distribution unit of clause 5, wherein the first period is longer than the second period.
7. The coolant distribution unit of clause 5, wherein the first pump speed corresponds to an intermediate operational speed.
8. The coolant distribution unit of clause 5, wherein the second pump speed corresponds to a final operational speed.
9. The coolant distribution unit of any one of the preceding clauses, wherein the second pump speed corresponds to a setpoint speed.
10. The coolant distribution unit of any one of the preceding clauses, wherein plurality of pumps includes three pumps.
11. The coolant distribution unit of any one of the preceding clauses, wherein, in response to determining that the pump has been enabled, the controller is further configured to adjust a pump speed of each pump of the plurality of pumps to the first pump speed.
12. The coolant distribution unit of any one of the preceding clauses, wherein, after the first period, the controller is further configured to adjust a pump speed of each pump of the plurality of pumps to the second pump speed.
13. A method comprising:
   determining whether a pump of a plurality of pumps has been enabled after previously being disabled, the plurality of pumps being associated with a coolant distributing unit;
   in response to a determination that that the pump has been enabled after previously being disabled: adjusting a pump speed of the pump to a first pump speed; and
   adjusting a pump speed of at least one other pump of the plurality of pumps to the first pump speed; and
   after a first period, adjusting the pump speed of the pump and the pump speed of the at least one other pump to a second pump speed.
14. The method of clause 13, wherein adjusting the pump speed of the pump to the first pump speed includes ramping up the pump speed of the pump to the first pump speed.
15. The method of clause 13, wherein adjusting the pump speed of the at least one other the pump to the first pump speed includes ramping down the pump speed of the at least one other pump to the first pump speed.
16. The method of clause 13, further comprising adjusting the pump speed of the pump to the first pump speed over the first period.
17. The method of any one of clauses 13-16, further comprising adjusting the pump speed of the at least one other pump to the first pump speed over a second period.
18. The method of clause 17, wherein the first period is longer than the second period.
19. The method of clause 17 or 18, wherein the first pump speed corresponds to an intermediate operational speed.
20. The method of clause 17, wherein the second pump speed corresponds to a final operational speed.

The above-described examples, implementations, and aspects have been described in order to allow easy understanding of the present disclosure and do not limit the present disclosure. On the contrary, the disclosure is intended to cover various modifications and equivalent arrangements included within the scope of the appended claims, which scope is to be accorded the broadest interpretation to encompass all such modifications and equivalent structure as is permitted under the law.

## Claims

1. A coolant distribution unit of a liquid cooling system, the coolant distribution unit comprising:
a plurality of pumps configured to circulate coolant within the liquid cooling system; and
a controller communicatively coupled to the plurality of pumps, the controller configured to:
determine whether a pump of the plurality of pumps has been enabled after previously being disabled;
in response to determining that the pump has been enabled:
adjust a pump speed of the pump to a first pump speed; and
adjust a pump speed of at least one other pump of the plurality of pumps to the first pump speed; and
after a first period, adjust the pump speed of the pump and the pump speed of the at least one other pump to a second pump speed.

2. The coolant distribution unit of claim 1, wherein the controller is further configured adjust the pump speed of the pump to the first pump speed by ramping up the pump speed of the pump to the first pump speed.

3. The coolant distribution unit of claim 1, wherein the controller is further configured adjust the pump speed of the at least one other the pump to the first pump speed by ramping down the pump speed of the at least one other pump to the first pump speed.

4. The coolant distribution unit of claim 1, wherein the controller is further configured to adjust the pump speed of the pump to the first pump speed over the first period.

5. The coolant distribution unit of claim 4, wherein the controller is further configured to adjust the pump speed of the at least one other pump to the first pump speed over a second period.

6. The coolant distribution unit of claim 5, wherein the first period is longer than the second period.

7. The coolant distribution unit of claim 5, wherein the first pump speed corresponds to an intermediate operational speed.

8. The coolant distribution unit of claim 5, wherein the second pump speed corresponds to a final operational speed.

9. The coolant distribution unit of any one of the preceding claims, wherein the second pump speed corresponds to a setpoint speed.

10. The coolant distribution unit of any one of the preceding claims, wherein plurality of pumps includes three pumps.

11. The coolant distribution unit of any one of the preceding claims, wherein, in response to determining that the pump has been enabled, the controller is further configured to adjust a pump speed of each pump of the plurality of pumps to the first pump speed; or optionally wherein, after the first period, the controller is further configured to adjust a pump speed of each pump of the plurality of pumps to the second pump speed.

12. A method comprising:
determining whether a pump of a plurality of pumps has been enabled after previously being disabled, the plurality of pumps being associated with a coolant distributing unit;
in response to a determination that that the pump has been enabled after previously being disabled:
adjusting a pump speed of the pump to a first pump speed; and
adjusting a pump speed of at least one other pump of the plurality of pumps to the first pump speed; and
after a first period, adjusting the pump speed of the pump and the pump speed of the at least one other pump to a second pump speed.

13. The method of claim 12, wherein adjusting the pump speed of the pump to the first pump speed includes ramping up the pump speed of the pump to the first pump speed; or optionally wherein adjusting the pump speed of the at least one other the pump to the first pump speed includes ramping down the pump speed of the at least one other pump to the first pump speed.

14. The method of claim 13, further comprising adjusting the pump speed of the pump to the first pump speed over the first period; and optionally
further comprising adjusting the pump speed of the at least one other pump to the first pump speed over a second period.

15. The method of claim 14, wherein the first period is longer than the second period; or optionally
wherein the first pump speed corresponds to an intermediate operational speed; or optionally wherein the second pump speed corresponds to a final operational speed.
